(19) **Europäisches Patentamt / European Patent Office / Office européen des brevets**

(11) **EP 0 741 299 B1**

(12) **EUROPÄISCHE PATENTSCHRIFT**

(45) Veröffentlichungstag und Bekanntmachung des Hinweises auf die Patenterteilung:
**24.01.2007 Patentblatt 2007/04**

(21) Anmeldenummer: **96104109.2**

(22) Anmeldetag: **14.03.1996**

(51) Int Cl.:
*G01R 27/26* (2006.01)   *G01R 19/10* (2006.01)
*G01D 5/241* (2006.01)   *G01F 23/26* (2006.01)
*G01L 1/14* (2006.01)   *G01L 9/12* (2006.01)
*G01N 27/22* (2006.01)   *G01P 15/125* (2006.01)

(54) **Schaltungsanordnung zur Bestimmung von Kapazitätsdifferenzen**

Circuit for determining differences in capacity

Circuit de détermination des différences de capacité

(84) Benannte Vertragsstaaten:
**DE GB IT NL**

(30) Priorität: **06.04.1995 DE 19513022**

(43) Veröffentlichungstag der Anmeldung:
**06.11.1996 Patentblatt 1996/45**

(73) Patentinhaber: **Infineon Technologies AG**
**81669 München (DE)**

(72) Erfinder:
• **Tielert, Reinhard, Prof.-Dr.**
**67722 Winnweiler (DE)**

• **Hildebrandt, Andreas**
**67346 Speyer (DE)**

(74) Vertreter: **Müller - Hoffmann & Partner**
**Patentanwälte,**
**Innere Wiener Strasse 17**
**81667 München (DE)**

(56) Entgegenhaltungen:
**US-A- 4 459 541     US-A- 5 028 876**
**US-A- 5 194 819**

**Beschreibung**

Die Erfindung betrifft eine Vorrichtung und ein Verfahren zur digitalen Messung des Kapazitätsunterschieds zweier Kondensatoren.

Eine derartige Vorrichtung oder Schaltungsanordnung kann beispielsweise zur digitalen Auswertung von Differential-Kondensatoren dienen. Differential-Kondensatoren werden häufig in der Sensortechnik zur Messung von Druck, Beschleunigung, Feuchte, Neigung usw. eingesetzt. Es wurden bereits verschiedene Einrichtungen zur Messung von Kapazitätsunterschieden vorgeschlagen (s. z. B. DE 36 23 136, US 43 92 378, DE 41 03 433, EP 0 503 272). Bei den bekannten Verfahren wird die Meßgröße (Kapazitätsunterschied) entweder durch den Wert einer Spannung (bzw. eines Stroms) oder durch das Tastverhältnis eines PWM-Signals repräsentiert. Für eine digitale Verarbeitung muß auf jeden Fall eine zusätzliche A/D-Wandlung stattfinden.

US 5 028 876 A offenbart Verfahren und Schaltungsanordnungen. Zum Ermitteln von Kapazitätsunterschieden.

Der Erfindung liegt die Aufgabe zugrunde, eine Vorrichtung anzugeben, die ermöglicht, den Kapazitätsunterschied zweier Kondensatoren zu messen und digital auszugeben, ohne jedoch zusätzlich zur Meßschaltung einen A/D-Wandler zu benötigen. Die Vorrichtung soll so beschaffen sein, daß eine Realisierung mit handelsüblichen Bauteilen auf möglichst einfache Weise möglich ist und auch ggf. eine Integration problemlos erfolgen kann. In einer weiteren Ausgestaltung soll die Vorrichtung ermöglichen, vorhandene parasitäre Kapazitäten aus der Ermittlung des Meßergebnisses zu eliminieren.

Diese Aufgabe wird mit der Schaltungsanordnung mit den Merkmalen des Anspruches 1 und mit dem Verfahren zur Messung von Kapazitätsdifferenzen unter Verwendung dieser Schaltungsanordnung nach Anspruch 8 oder 9 gelöst. Weitere Ausgestaltungen ergeben sich jeweils aus den abhängigen Ansprüchen.

Bei der erfindungsgemäßen Schaltungsanordnung wird mit dem einen Kondensator ein positiver Strom und mit dem anderen Kondensator ein negativer Strom integriert, wobei die Spannung des nicht für die Integration benutzten Kondensators der Spannung des für die Integration benutzten Kondensators nachgeführt wird und eine Ablaufsteuerung die Zeitdauern der einzelnen Integrationen mißt, daraus einen Wert berechnet und digital ausgibt sowie die Integrationszyklen derart steuert, daß die Spannung auf den Kondensatoren innerhalb eines vorgegebenen Bereiches bleibt.

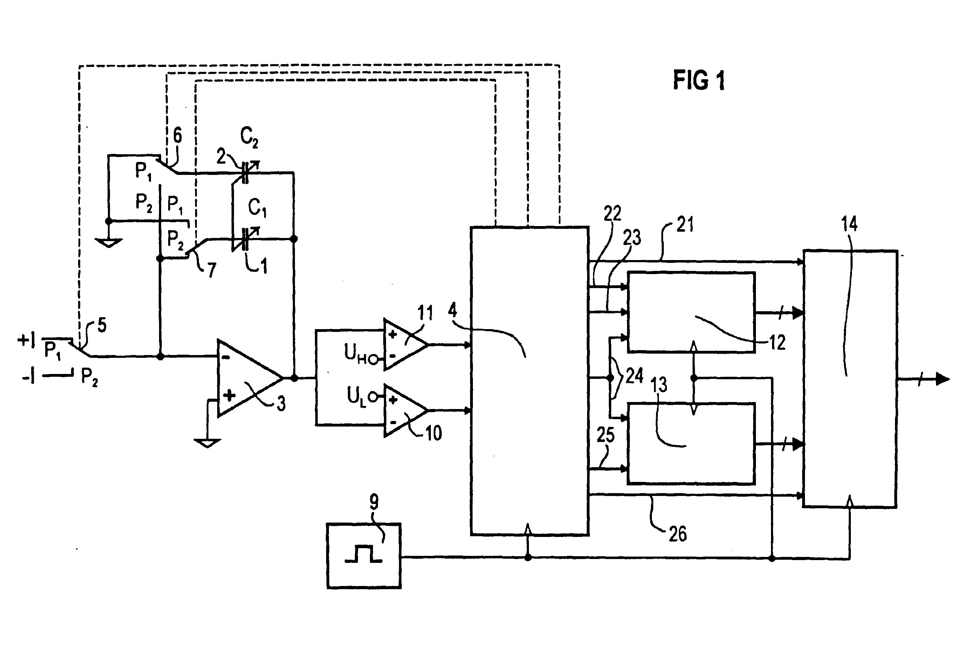

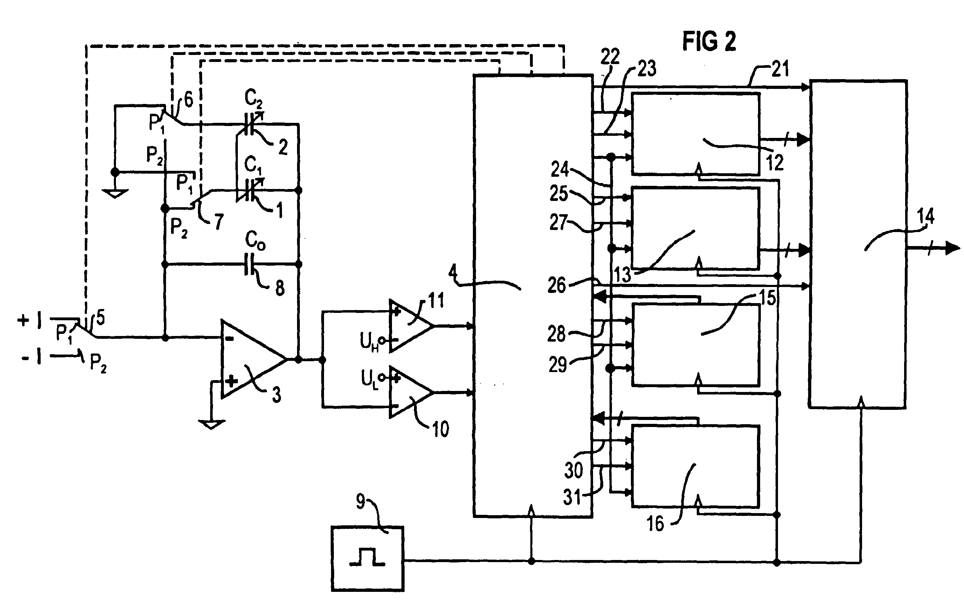

Es folgt eine genauere Beschreibung dieser Schaltungsanordnung und des Meßverfahrens anhand der Figuren 1 und 2, die jeweils Prinzipschaltbilder dieser Schaltungsanordnung zeigen.

Bei der in Figur 1 dargestellten Schaltungsanordnung sind die beiden Kondensatoren 1, 2 eingezeichnet, für die z. B. der Quotient der Kapazitäten oder die auf die Summe der Kapazitäten bezogene Differenz der Kapazitäten (relativer Kapazitätsunterschied) festgestellt werden soll. An diese Kondensatoren 1, 2 kann abwechselnd ein Integrator angeschaltet werden, der aus einer Stromquelle mit positivem Ausgangsstrom (positive Stromquelle +I) abwechselnd mit einer Stromquelle mit negativem Ausgangsstrom (negative Stromquelle -I) gespeist wird. Eine erste Schaltungsvorrichtung 5, die in diesem Ausführungsbeispiel durch einen ersten Schalter 5 gebildet wird, ermöglicht es, alternativ die eine oder die andere Stromquelle zuzuschalten. Die Stromquellen liefern jeweils einen Strom mit konstanter Stromstärke, der an den invertierenden Eingang eines Differenzverstärkers 3 geführt wird. Der nicht invertierende Eingang dieses Differenzverstärkers 3 ist mit einem Masseanschluß verbunden. Je ein Anschluß der beiden auszumessenden Kondensatoren 1, 2 ist mit dem Ausgang dieses Differenzverstärkers 3 verbunden. Es ist eine zweite Schaltungsvorrichtung vorhanden, die in dem in Figur 1 dargestellten Ausführungsbeispiel durch einen zweiten Schalter 6 und einen dritten Schalter 7 gebildet wird. Diese zweite Schaltungsvorrichtung 6, 7 ist so eingerichtet, daß sie ermöglicht, jeweils einen Anschluß der Kondensatoren 1, 2 entweder mit dem Masseanschluß (Bezugspotential an dem nicht invertierenden Eingang des Differenzverstärkers 3) oder mit dem invertierenden Eingang des Differenzverstärkers 3 (virtuelle Masse) zu verbinden. Diese Schaltungsanordnung bewirkt, daß die Spannungen an den beiden Kondensatoren jederzeit übereinstimmen.

Die synchrone Umschaltung der drei Schalter 5, 6, 7 wird durch eine Ablauf-Steuerung bewirkt, die eine hinter dem Ausgang des Differenzverstärkers 3 angeordnete Steuereinrichtung 4 umfaßt. Diese Steuereinrichtung 4 verfügt außerdem über einen Spannungsmesser, der die an den Kondensatoren anliegende Spannung mißt. Die Steuereinrichtung 4 verfügt außerdem über einen Zeitmesser und Mittel zur Addition von festgestellten Zeitdauern. Vorzugsweise ist die Steuereinrichtung 4 mit einem Taktgeber verbunden. Die Zeiten können dann digital addiert und in dieser Form für die weitere Rechnung und die Ausgabe des Ergebnisses verarbeitet werden. Bei einer bevorzugten Ausgestaltung der erfindungsgemäßen Schaltungsanordnung liefert diese Steuereinrichtung 4 sofort das rechnerisch ermittelte Ergebnis für den Wert des Kapazitätsunterschieds. Für weitergehende Ausgestaltungen dieser Schaltungsanordnung ist es vorteilhaft, wenn der erste Schalter 5 unabhängig von den übrigen Schaltern betätigt werden kann oder wenn der erste Schalter 5 jeweils nur mit einem der beiden anderen Schalter synchron umgeschaltet werden kann. Statt einer synchronen Steuerung separater Schalter kann ein z. B. durch eine elektronische Schaltung realisierter Mehrfachschalter vorhanden sein, der so konstruiert ist, daß er beim Umschalten gleichzeitig alle umzuschaltenden Verbindungen entsprechend verändert. Auch bei einer solchen Realisierung der beiden Schaltungsvorrichtungen kann die in dem gemeinsamen Schalter integrierte erste Schaltungsvorrichtung von der zweiten Schaltungsvorrichtung unterschieden werden. Die separate Bezeichnung dieser Schaltungsvorrichtungen und die Beschreibung der konkreten Ausführungsform nach Figur 1 stellen daher keine Einschränkung an die möglichen weiteren Ausführungsformen dieser Schaltungsanordnung dar. Die in Figur 1 dargestellte Anordnung ist wegen der besonders einfachen Ausgestaltung vorteilhaft.

Zur Erläuterung der Funktionsweise dieser Anordnung wird im folgenden zunächst das Meßverfahren beschrieben. Zu Beginn einer Messung sind die Kondensatoren vorzugsweise ganz oder zumindest weitgehend entladen. Die erste Schaltvorrichtung (erster Schalter 5) wird in eine erste Schaltposition $P_1$ geschaltet, in der in dem in Figur 1 angegebenen Beispiel die positive Stromquelle +I mit dem invertierenden Eingang des Differenzverstärkers 3 verbunden ist. In der in Figur 1 dargestellten Ausgangsposition ist mittels der zweiten Schaltvorrichtung der erste Kondensator 1 mit dem invertierenden Eingang des Differenzverstärkers verbunden, während der zweite Kondensator 2 mit dem Masseanschluß verbunden ist. Es wird daher zunächst der von der positiven Stromquelle +I gelieferte Strom integriert, indem der erste Kondensator auf eine bestimmte Spannung aufgeladen wird. Die Schaltungsanordnung bewirkt, daß wegen des Differenzverstärkers der zweite-Kondensator 2 auf dieselbe Spannung geladen wird. Das Aufladen des ersten Kondensators 1 erfolgt z. B. während einer vorgegebenen Zeitdauer. Diese Zeitdauer wird von der Steuereinrichtung überwacht, in der z. B. diese Zeit fest vorgegeben oder durch einen angeschlossenen Taktgeber bestimmt wird. Es kann statt dessen über den Spannungsmesser kontrolliert werden, daß die Spannung an den Kondensatoren nur bis zu einem bestimmten Wert ansteigt, und dann die Integration des Stromes unterbrochen werden. Nach Ablauf dieser bestimmten Integrationszeit werden von der Steuereinrichtung 4 die erste und die zweite Schaltvorrichtung 5, 6, 7 synchron umgeschaltet, so daß jetzt der Strom aus der anderen Stromquelle (in diesem Beispiel die negative Stromquelle -I) mit entgegengesetzter Flußrichtung integriert wird und der zuvor mit dem Masseanschluß verbundene Kondensator mit dem invertierenden Eingang des Differenzverstärkers verbunden ist und der andere Kondensator mit dem Masseanschluß verbunden ist. Diese zweite Integration, bei der der Strom in der entgegengesetzten Richtung fließt, wird so lange durchgeführt, wie der in der Steuereinrichtung 4 vorgegebenen Zeitdauer oder der Taktrate entspricht oder bis die an den Kondensatoren anliegende Spannung einen bestimmten Wert unterschreitet. Dieser Wert kann z. B. das durch den Masseanschluß gegebene Bezugspotential sein. Daraufhin werden alle Schalter gleichzeitig in die Ausgangsposition gebracht, so daß ein weiterer Integrationszyklus stattfinden kann, bei dem wieder zunächst der erste Kondensator mit dem positiven Strom geladen und dann der zweite Kondensator mit dem negativen Strom entladen wird, wobei der Differenzverstärker jeweils die Spannung auf dem anderen Kondensator angleicht. Die Steuereinrichtung 4 kann dabei z. B. die Integrationszeiten so einstellen, daß nach jedem Integrationszyklus wieder die Ausgangsspannung auf den Kondensatoren anliegt. Die Spannung an den Kondensatoren kann sich aber auch nach jedem Integrationszyklus verändern, wobei allerdings für die Auswertung der Meßergebnisse vorzugsweise zumindest die letzte Integrationsdauer so gewählt wird, daß am Schluß die ursprünglich an den Kondensatoren anliegende Spannung wieder erreicht ist. Aus den für die Ermittlung des Ergebniswertes verwendeten Gleichungen fallen dann nämlich die Summen der Spannungsänderungen beim Auf- bzw. Entladen der Kondensatoren heraus.

Die Auswertung der Messung benutzt die für Kondensatoren geltende Gleichung CU = Q, wobei hier die Ladung Q wegen des konstanten Stromes gleich ist dem Produkt aus Stromstärke und Zeit. Diese Gleichung wird bei n Integrationszyklen n-mal angewendet. Die sich daraus ergebende Berechnung führt zu den nachfolgenden Gleichungen. Darin bedeuten:

$I_+$, $I_-$ den Betrag der Stromstärke des Stromes aus der positiven bzw. negativen Stromquelle,

$C_+$, $C_-$ die Kapazität des jeweils mit der positiven bzw. negativen Stromquelle verschalteten Kondensators,

$C_1$, $C_2$ die Kapazität des ersten bzw. zweiten Kondensators,

$C_0$ die Kapazität eines weiteren Kondensators,

$t_+$, $t'_+$, $t''_+$ Zeiten, während derer von der positiven Stromquelle +I geladen wird,

$t_-$, $t'_-$, $t''_-$ Zeiten, während derer von der negativen Stromquelle -I entladen wird,

$U_+$, $U'_+$, $U''_+$, $U_-$, $U'_-$, $U''_-$ Spannungsdifferenzen, die jeweils beim Aufladen bzw. Entladen an den Kondensatoren hervorgerufen werden.

In den nachfolgenden Gleichungen bedeutet der kleine Buchstabe als unterer Index des Summenzeichens jeweils den Laufindex, mit dem die jeweils zu einem Integrationszyklus gehörenden Größen durchnumeriert werden. Das Pluszeichen als Index kennzeichnet jeweils ein Zeitintervall und eine darin erfolgte Spannungsänderung während des Anschlusses an die positive Stromquelle +I, d. h. in dem Ausführungsbeispiel der Figur 1 ist der erste Schalter 5 in Position $P_1$. Das Minuszeichen bedeutet entsprechend die Zeitintervalle bzw. Spannungsänderungen während des Anschlusses an die negative Stromquelle -I, d. h. speziell der erste Schalter 5 in der zweiten Schaltposition $P_2$. Die Berechnung geht aus von den folgenden Gleichungen:

$$I_+ \, \Sigma_f t_{+f} = C_+ \, \Sigma_f U_{+f}$$

$$I_- \ \Sigma_g t_{-g} = C_- \ \Sigma_g U_{-g}$$

Falls die Ladezeiten und Spannungsänderungen separat während der Messung summiert werden, läßt sich aus diesen Gleichungen bei Kenntnis der Stromstärken bereits die Differenz oder der Quotient der Kapazitäten bestimmen. Falls man die Messung so einrichtet, daß $\Sigma_f U_{+f} = \Sigma_g U_{-g}$, dann folgt aus den Gleichungen

$$C_+ \ I_- \ \Sigma_g t_{-g} = C_- \ I_+ \ \Sigma_f t_{+f}.$$

Um die Summe der Spannungsänderungen bei der Auf- und Abintegration gleich einzustellen, ist es nur erforderlich, mittels eines Spannungsmessers festzustellen, wann die an den Kondensatoren anliegende Spannung wieder den Anfangswert erreicht. In diesem Moment wird das Auf- oder Entladen der Kondensatoren unterbrochen, und die beiden Summen über die positiven und negativen Spannungsänderungen sind dann gleich. Statt aus der zuletzt angegebenen Gleichung den Quotienten der Kapazitäten zu bestimmen, kann man die relative Kapazitätsdifferenz ermitteln, d. h. die Differenz der Kapazitäten dividiert durch die Summe der Kapazitäten:
$(C_+-C_-)/(C_++C_-)$ aus der aus der vorhergehenden Gleichung abgeleiteten Gleichung

$$(C_+-C_-) \ (I_+ \ \Sigma_f t_{+f} + I_- \ \Sigma_g t_{-g}) =$$
$$(C_+ + C_-) \ (I_+ \ \Sigma_f t_{+f} - I_- \ \Sigma_g t_{-g}).$$

Besonders vorteilhaft ist es, wenn die beiden Stromquellen +I, -I Ströme liefern, deren Stromstärken denselben Betrag $I_+$, $I_-$ haben. Dieser Wert fällt dann aus der letzten Gleichung heraus. Falls die Kapazitäten der Kondensatoren bekannt sind, kann die Differenz der Kapazitäten mit dieser Methode relativ genau bestimmt werden, auch wenn die Meßgenauigkeit der einzelnen Kapazitäten für die Bestimmung dieser Differenz nicht ausreicht. Diese Schaltungsanordnung und dieses Meßverfahren können selbstverständlich auch dazu benutzt werden, die Kapazität eines Kondensators sehr genau zu ermitteln aus der Differenz zwischen dieser unbekannten Kapazität und der sehr genau bestimmten Kapazität eines zweiten, als Bezugsgröße benutzten Kondensators.

Durch eine Weiterbildung der Erfindung können Einflüsse von parasitären Kapazitäten auf das Meßergebnis eliminiert werden oder bei Verwendung eines dritten Kondensators, dessen Kapazität sehr genau bestimmt ist, die Kapazitätsdifferenz der beiden zu messenden Kondensatoren auch absolut sehr genau angegeben werden. Diese Weiterbildung der Erfindung wird anhand der Figur 2 erläutert, in der ein weiterer Kondensator 8 parallel zu dem Differenzverstärker 3 zwischen dessen invertierendem Eingang und dessen Ausgang vorhanden ist. Dieser weitere Kondensator 8 kann entweder ein weiteres Bauelement sein oder eine in der Schaltungsanordnung ohnehin vorhandene parasitäre Kapazität, wobei die Figur 2 dann nur das Ersatzschaltbild einer realen Schaltung nach Figur 1 darstellt. Das Meßverfahren gestaltet sich dann z. B. wie folgt.

In der ersten Phase der Integration befinden sich der erste Schalter 5 und der zweite Schalter 6 z. B. wie dargestellt in der ersten Schaltposition $P_1$. Der dritte Schalter 7 befindet sich in der anderen Schaltposition $P_2$, so daß der erste Kondensator 1 mit der positiven Stromquelle +I verbunden ist und der zweite Kondensator 2 an dem Masseanschluß liegt. Mit dem positiven Strom werden dann der erste Kondensator 1 und der weitere Kondensator 8 gemeinsam geladen, wobei der Differenzverstärker 3 den zweiten Kondensator 2 auf dieselbe Spannung lädt. Danach werden nur der erste Schalter 5 in die Schaltposition $P_2$ und der dritte Schalter 7 synchron dazu in die erste Schaltposition $P_1$ umgeschaltet. Mit dem negativen Strom aus der Stromquelle -I wird dann nur der weitere Kondensator 8 entladen, während die Spannung an den beiden mit dem Masseanschluß verbundenen Kondensatoren von dem Differenzverstärker nachgeführt wird.

Erneutes Umschalten des ersten Schalters 5 und des dritten Schalters 7 leitet den nächsten Integrationszyklus ein. Statt in der in Figur 2 dargestellten Konstellation der Schaltpositionen zu beginnen, können auch zunächst der zweite Schalter 6 und der dritte Schalter 7 beide in der Schaltposition $P_1$ sein, so daß der erste Kondensator 1 und der zweite Kondensator 2 beide mit dem Masseanschluß verbunden sind. Mit dem positiven Strom aus der Stromquelle +I wird dann zunächst nur der weitere Kondensator 8 bzw. die parasitäre Kapazität geladen. Anschließend werden der weitere Kondensator 8 und z. B. der erste Kondensator 1 nach Anschluß an die negative Stromquelle -I gemeinsam entladen. Es kann auch mit dem negativen Strom aus der negativen Stromquelle -I begonnen werden. Vorzugsweise wird der Vorgang des abwechselnden Ladens und Entladens in einem Moment beendet, in dem die an den Kondensatoren anliegende Spannung den Ausgangswert wieder erreicht hat.

Es erfolgt dann ein zweiter Abschnitt des Verfahrens, in dem z. B. mit dem Laden nur des weiteren Kondensators 8 begonnen wird. Dazu werden der zweite Schalter 6 und der dritte Schalter 7 beide in die Schaltposition $P_1$ gebracht, also beide Kondensatoren an den Masseanschluß gelegt. Es wird dann erneut der weitere Kondensator 8 geladen, nach der Ladezeit aber jetzt der erste Schalter 5 und der zweite Schalter 6 in die andere Schaltposition $P_2$ umgeschaltet. Danach werden also der zweite Kondensator 2 und der weitere Kondensator 8 gemeinsam entladen. Erneut werden der erste Schalter 5 und der zweite Schalter 6 umgeschaltet und wieder der weitere Kondensator 8 bzw. die parasitäre Kapazität geladen, erneut umgeschaltet, wobei jetzt jeweils der erste Schalter 5 und der zweite Schalter 6 synchron betätigt werden. Diese Integrationszyklen werden beendet, wenn die Spannung auf den Kondensatoren erneut den Anfangswert erreicht hat. Für die Auswertung des Meßergebnisses ist es besonders vorteilhaft, wenn für den ersten Abschnitt des Meßverfahrens, in dem der erste Schalter 5 synchron immer mit dem einen der beiden anderen Schalter umgeschaltet wird, die Summe aller Integrationszeiten nur des weiteren Kondensators - also wenn z. B. alle Schalter in der Schaltposition $P_1$ sind - genauso groß ist wie die Summe der Integrationszeiten nur des weiteren Kondensators in dem zweiten Abschnitt des Verfahrens, wenn der erste Schalter 5 synchron immer mit dem anderen der beiden Schalter umgeschaltet wird. Wie weiter unten anhand der für die Berechnung herangezogenen Gleichungen näher erläutert wird, vereinfacht sich die Auswertung dadurch erheblich.

Es muß auch bei dieser Ausführung der Erfindung ein Spannungsmesser vorhanden sein, der die an den Kondensatoren anliegende Spannung an die Steuereinrichtung übermittelt. Falls die Kapazität des weiteren Kondensators 8 nicht bekannt ist, muß die Steuereinrichtung Mittel aufweisen, die eine Addition der Spannungsänderungen jeweils für eine bestimmte Konstellation der Schaltpositionen sämtlicher Schalter für jeden Abschnitt des Verfahrens gesondert ermöglichen. Es ist für die Eliminierung des Einflusses einer parasitären Kapazität, wenn also die Kapazität des weiteren Kondensators 8 nicht bekannt ist, wesentlich, daß das Verfahren so durchgeführt wird, daß die vier Summen der Beträge der Spannungsänderungen jeweils für jeden Abschnitt des Verfahrens und für jede Konstellation der Schaltpositionen der drei Schalter gesondert addiert gleich sind. Diese Addition der Beträge der Spannungsänderungen kann jeweils indirekt erfolgen, weil die Stromstärken des Ladestromes und des Entladestromes jeweils konstant bleiben. Jede Spannungsänderung ist daher proportional zu der jeweiligen Dauer des Ladens bzw. Entladens. Es genügt daher, wenn in dem ersten Abschnitt des Verfahrens alle Zeitintervalle, während derer sowohl der erste Kondensator als auch der zweite Kondensator mit dem Masseanschluß verbunden sind, addiert werden und am Ende dieses Abschnittes über den Spannungsmesser kontrolliert wird, daß die an den Kondensatoren anliegende Spannung den Anfangswert wieder erreicht hat, und wenn in dem zweiten Abschnitt die Integrationszyklen so oft erfolgen, daß die Summe der Zeitintervalle, während derer wieder sowohl der erste Kondensator als auch der zweite Kondensator mit dem Masseanschluß verbunden sind, gleich dieser Summe aus dem ersten Abschnitt ist. Es braucht dann nur durch den Spannungsmesser kontrolliert zu werden, daß auch am Ende des zweiten Abschnitts des Verfahrens die an den Kondensatoren anliegende Spannung den Anfangswert erreicht, damit die vier Summen der für die Abschnitte und Schaltpositionen gesondert addierten Beträge der Spannungsänderungen alle gleich sind. Die Summierung der jeweiligen Zeitintervalle kann unter Verwendung eines an die Steuereinrichtung angeschlossenen Taktgebers digital durch einfaches Aufzählen der Taktsignale erfolgen.

Für den ersten Abschnitt dieses Verfahrens, in dem jeweils der weitere Kondensator 8 einzeln oder zusammen mit dem ersten Kondensator 1 geladen bzw. entladen wird, erhält man die folgenden beiden Grundgleichungen, in denen $C_0$ die Kapazität des weiteren Kondensators 8 und $C_1$ die Kapazität des ersten Kondensators 1 sowie $t_+$, $t_-$ die Zeiten, während derer jeweils der erste Schalter 5 in der Schaltposition $P_1$ bzw. $P_2$ war und $U_+$ und $U_-$ die Beträge der zugehörigen Änderungen der an den Kondensatoren anliegenden Spannung bedeuten:

$$I_+ \; \Sigma_f t_{+f} \; = \; C_0 \; \Sigma_f U_{+f}$$

$$I_- \; \Sigma_g t_{-g} \; = \; (C_0 + C_1) \; \Sigma_g U_{-g}$$

Für den zweiten Abschnitt des Verfahrens ergeben sich entsprechend die folgenden Grundgleichungen, in denen zur Unterscheidung der Zeiten und Spannungsänderungen gegenüber dem ersten Abschnitt des Verfahrens die Variablen jeweils mit einem Strich versehen sind:

$$I_+ \; \Sigma_h t'_{+h} \; = \; C_0 \; \Sigma_h U'_{+h}$$

$$I_- \; \Sigma_i t'_{-i} \; = \; (C_0 + C_2) \; \Sigma_i U'_{-i}$$

Wenn wie beschrieben nach jedem Abschnitt des Verfahrens die an den Kondensatoren anliegende Spannung den Anfangswert wieder erreicht, gilt demnach $\Sigma_f U_{+f} = \Sigma g U_{-g}$ und $\Sigma_h U'_{+h} = \Sigma_i U'_{-i}$. Jedes Paar von Grundgleichungen liefert damit eine der folgenden Gleichungen:

$$C_0 \ I_- \ \Sigma_g t_{-g} = (C_0 + C_1) \ I_+ \ \Sigma_f t_{+f}$$

$$C_0 \ I_- \ \Sigma_i t'_{-i} = (C_0 + C_2) \ I_+ \ \Sigma_h t'_{+h}$$

Auflösen dieser Gleichungen nach $C_1$ bzw. $C_2$ und Subtraktion liefert

$$(C_1 - C_2) \ I_+ \ \Sigma_f t_{+f} \ \Sigma_h t'_{+h} =$$
$$= C_0 \ I_- \ (\Sigma_g t_{-g}, \ \Sigma_h t'_{+h} - \Sigma_f t_{+f} \ \Sigma_i t'_{-i}).$$

Falls, wie oben bereits beschrieben, vorteilhaft die Summen der Ladezeiten des weiteren Kondensators 8 alleine in beiden Abschnitten des Verfahrens gleich gewählt werden, also $\Sigma_f t_{+f} = \Sigma_h t'_{+h}$ gilt, dann läßt sich die vorstehende Gleichung vereinfachen zu

$$(C_1 - C_2) \ I_+ \ \Sigma_f t_{+f} = C_0 \ I_- \ (\Sigma_g t_{-g} - \Sigma_i t'_{-i}) \qquad (\text{Glg.1})$$

Bei Kenntnis der Kapazität $C_0$ des weiteren Kondensators 8 läßt sich aus dieser Gleichung die Differenz der Kapazitäten $C_1$ des ersten Kondensators 1 und $C_2$ des zweiten Kondensators 2 bestimmen.

Falls es sich bei dem weiteren Kondensator 8 um eine nicht bekannte parasitäre Kapazität handelt, wird bei der Berechnung die jeweils erste Gleichung der beiden Paare von Grundgleichungen nach $C_0$ aufgelöst und der sich ergebende Term in die jeweils zweite Gleichung eingesetzt. Dabei werden wieder $\Sigma_f U_{+f} = \Sigma_g U_{-g}$ und $\Sigma_h U'_{+h} = \Sigma_i U'_{-i}$ berücksichtigt. Nach dem Einsetzen folgt dann aus den beiden zweiten Gleichungen der Paare von Grundgleichungen die Gleichung

$$(C_1 - C_2)(I_- \ \Sigma_g t_{-g} - I_+ \ \Sigma_h t'_{+h} \ \Sigma_f U_{+f}/\Sigma_h U'_{+h} +$$
$$+ I_- \ \Sigma_i t'_{-i} \ \Sigma_f U_{+f}/\Sigma_h U'_{+h} - I_+ \ \Sigma_f t_{+f}) =$$
$$= (C_1 + C_2)(I_- \ \Sigma_g t_{-g} - I_- \ \Sigma_i t'_{-i} \ \Sigma_f U_{+f}/\Sigma_h U'_{+h} +$$
$$+ I_+ \ \Sigma_h t'_{+h} \ \Sigma_f U_{+f}/\Sigma_h U'_{+h} - I_+ \ \Sigma_f t_{+f}).$$

Falls wie oben erläutert in jedem Abschnitt des Verfahrens die Summen der Beträge der Spannungsänderungen jeweils in einer Richtung gleich groß sind, d. h. falls $\Sigma_f U_{+f} = \Sigma_h U'_{+h}$ gilt, dann gilt wegen der ersten und dritten Grundgleichung auch $\Sigma_f t_{+f} = \Sigma_h t'_{+h}$. Die vorstehende Gleichung vereinfacht sich dann zu

$$(C_1 - C_2)(I_- \ \Sigma_g t_{-g} + I_- \ \Sigma_i t'_{-i} - 2 \ I_+ \ \Sigma_f t_{+f}) =$$
$$= (C_1 + C_2)(I_- \ \Sigma_g t_{-g} - I_- \ \Sigma_i t'_{-i}) \qquad (\text{Glg.2}).$$

Aus dieser Gleichung läßt sich wieder der Quotient $(C_1-C_2)/(C_1 + C_2)$ der relativen Kapazitätsdifferenz berechnen.

Für die Auswertung muß der Quotient der Beträge der Stromstärken $I_+/I_-$ bekannt sein. Vorteilhafterweise benutzt man Stromquellen, die Ströme gleichen Betrages der Stromstärke, aber entgegengesetzter Flußrichtung liefern. Falls das nicht möglich ist oder aufgrund anderer Schaltungskomponenten nicht erwünscht ist, können die Beträge der von der positiven Stromquelle +I und der negativen Stromquelle -I gelieferten Ströme auch anders eingestellt werden. Falls die Stromstärken nicht bekannt sind, können sie auch aus der erfindungsgemäßen Schaltungsanordnung ermittelt werden. Dazu bedarf es einer Bezugsmessung, bei der jeweils nur eine feste Kapazität eines oder mehrerer der vorhandenen Kondensatoren benutzt wird. Falls nur die Kapazität $C_0$ des weiteren Kondensators 8 benutzt wird, werden der zweite Schalter 6 und der dritte Schalter 7 beide in die Schaltposition $P_1$ gebracht oder bei einer anderen Ausführung der zweiten Schaltvorrichtung entsprechend der erste Kondensator 1 und der zweite Kondensator 2 mit dem Masseanschluß verbunden. Für die Bezugsmessung kann aber auch jeweils einer der anderen Kondensatoren oder alle Kondensatoren gemeinsam benutzt werden. Wesentlich ist nur, daß die eingestellte Position der zweiten Schaltvorrichtung 6, 7 während dieser Messung nicht verändert wird. Die angeschalteten Kapazitäten werden ebenfalls für die Zeitdauer der Messung nicht geändert. Die erste Schaltvorrichtung 5 schaltet zwischen der positiven und der negativen Stromquelle hin und her. Es wird also abwechselnd eine bestimmte Zeit $t''_+$ geladen und eine Zeit $t''_-$ entladen. Die Zeiten, in denen die erste Schaltvorrichtung 5 jeweils in Schaltpositon $P_1$ ist, und die Zeiten, in denen die erste Schaltvorrichtung 5 jeweils in Schaltposition $P_2$ ist, werden gesondert addiert. Es ergeben sich so die $\Sigma_j t''_{+j}$ und $\Sigma_k t''_{-k}$. Die zugehörigen Beträge der Änderung der Spannung an dem geladenen bzw. entladenen Kondensator werden ebenfalls gesondert addiert zu den Summen $\Sigma_j U''_{+j}$ und $\Sigma_k U''_{-k}$. Es gelten dann die Gleichungen

$$I_+ \ \Sigma_j t''_{+j} \ = \ C \ \Sigma_j U''_{+j}$$

und

$I_- \Sigma_k t''_{-k} = C \Sigma_k U''_{-k}$, wobei C die Kapazität des betreffenden Kondensators ist. Falls der letzte Lade- oder Entladevorgang so lange dauert, daß $\Sigma_j U''_{+j} = \Sigma_k U''_{-k}$ gilt, was z. B. auf einfache Weise festgestellt werden kann dadurch, daß dann die an dem Kondensator anliegende Spannung gleich der Anfangsspannung ist, folgt aus den Gleichungen sofort

$$I_+ \ \Sigma_j t''_{+j} \ = \ I_- \ \Sigma_k t''_{-k}.$$

Aus dieser Gleichung läßt sich sofort der Quotient $I_+/I_-$ berechnen. Wenn bei den Messungen außerdem die Summen der Lade- bzw. Entladezeiten so gewählt werden, daß $\Sigma_f t_{+f} = \Sigma_j t''_{+j}$, dann vereinfachen sich die Gleichungen 1 und 2 zu

$$(C_1 \ - \ C_2) \ \Sigma_k t''_{-k} \ = \ C_0 \ (\Sigma_g t_{-g} \ - \ \Sigma_i t'_{-i}) \qquad \qquad (Glg.1')$$

bzw.

$$(C_1 \ - \ C_2)(\Sigma_g t_{-g} \ + \ \Sigma_i t'_{-i} \ - \ 2 \ \Sigma_k t''_{-k}) \ =$$
$$= \ (C_1 \ + \ C_2)(\Sigma_g t_{-g} \ - \ \Sigma_i t'_{-i}) \qquad \qquad (Glg.2').$$

Vernünftigerweise gestaltet sich die Integration so, daß entweder gleich oft geladen und entladen wird oder daß höchstens einmal mehr geladen oder entladen wird, also nicht hin und her geschaltet wird, ohne daß dazwischen ein Lade- oder Entladevorgang stattfindet. Die Anzahlen der zu jeweils einem Summationsindex gehörenden Summanden in den zusammengehörenden Paaren von Grundgleichungen sind daher entweder gleich oder höchstens um eins verschieden. Für die Berechnung ist, wie sich aus den angegebenen Gleichungen ergibt, erforderlich, daß die Steuereinrichtung 4, zu der ggf. eine Rechen- oder Auswerteeinrichtung zu zählen ist, über Mittel verfügt, mit denen die jeweils gemessenen Zeitintervalle addiert werden können, und daß die Steuereinrichtung 4 außerdem über Mittel verfügt, die bei Erreichen einer bestimmten Spannung an den Kondensatoren selbsttätig die Schaltvorrichtungen synchron umschaltet bzw. die Integration unterbricht. Ggf. müssen auch Mittel vorhanden sein, festgestellte Spannungsänderungen zu addieren und den Wert der Summe zu speichern, der dann anschließend mit einem anderen Wert verglichen werden können muß. Unter dem Summieren, Speichern und Vergleich von Spannungsdifferenzen ist immer, insbesondere bei der Auslegung der Patentansprüche, zu verstehen, daß diese Spannungsdifferenzen in Form von zu den tatsächlichen Spannungsdifferenzen proportionalen Zeitintervallen erfaßt sein können und die angegebenen Operationen mit diesen Zeitintervallen (Integrationszeiten) ausgeführt werden.

Bei der Eliminierung einer parasitären Kapazität genügt es z. B., wenn die Spannungsänderungen beim Laden der parasitären Kapazität durch die eine Stromquelle jeweils addiert werden. Dieser Wert wird von der Steuereinrichtung 4 gespeichert. Es wird außerdem durch Vergleich der an dem Kondensator anliegenden Spannung mit dem gespeicherten Anfangswert (z. B. Spannung 0 bei vollständiger Entladung) dafür gesorgt, daß nach dem ersten Abschnitt des Verfahrens die Kondensatoren wieder auf dem Anfangswert der Spannung sind. In dem zweiten Abschnitt des Verfahrens werden entsprechend wieder alle Spannungsänderungen addiert, die beim Laden nur der parasitären Kapazität alleine auftreten. Der Ladevorgang wird in dem Moment abgebrochen, in dem diese Summe der zuvor gespeicherten Summe entspricht. Das Entladen geschieht wieder bis zum Erreichen der Anfangsspannung. Auf diese Weise wird erreicht, daß die vier in den Gleichungen auftretenden Summen der Beträge der Spannungsänderungen gleich groß sind. Es braucht daher von der Steuereinrichtung 4 nur nach jedem zweiten Umschaltvorgang eine Spannungsdifferenz zu einem bereits gespeicherten Wert addiert zu werden und einmal zwischendurch der erreichte Maximalwert gespeichert und mit diesem die jeweils erreichten Zwischensummen der Spannungsänderungen verglichen zu werden. Das kann wie oben beschrieben direkt über das Abzählen von durch einen Taktgeber bestimmten gleich langen Zeitintervallen geschehen. Ein Vergleich von auf diese Weise festgestellten Anzahlen genügt für die Ablauf-Steuerung des Verfahrens, weil die jeweiligen Gesamtbeträge der Spannungsänderungen bei analoger Auswertung tatsächlich gemessener und addierter Spannungsänderungen auch nur miteinander auf Gleichheit verglichen werden müßten und der Betrag in Volt in der weiteren Berechnung nicht eingesetzt zu werden bräuchte.

Falls die beiden Stromstärken dem Betrage -nach gleich sind oder falls im Fall einer Bezugsmessung zur Ermittlung von $I_+/I_-$ die Summen der Ladezeiten wie oben beschrieben gleich gewählt werden, vereinfachen sich die zur Berechnung herangezogenen Gleichungen (s. Gleichungen 1' und 2') so, daß die relative Kapazitätsdifferenz bzw. die auf die Kapazität des weiteren Kondensators bezogene Kapazitätsdifferenz aus den verschiedenen Summen der Lade- und Entladezeiten einfach berechnet werden kann. Es brauchen daher nur diese Zeiten gesondert addiert zu werden und die jeweiligen Summen für die Berechnung gespeichert zu werden. Aus den der Berechnung zugrundezulegenden Gleichungen in der weitestgehend vereinfachten Form, die auf die beschriebenen bevorzugten Ausführungsformen des Meßverfahrens anwendbar sind, entnimmt man, daß das Ergebnis errechnet werden kann, indem nur Zeitintervalle addiert, subtrahiert, multipliziert und dividiert werden, wobei diese Zeiten durch eine bestimmte Anzahl von Taktsignalen, deren Abstand festgelegte kleinste Zeitintervalle bestimmt, definiert sind und folglich nur mit Anzahlen gerechnet werden muß.

Die Zeiten der Lade- und Entladevorgänge können alle bis auf die letzte gleich oder statt dessen verschieden gewählt werden. Die letzte Integrationszeit muß zur Vereinfachung der Rechnung jeweils so gewählt werden, daß die Anfangsspannung auf den Kondensatoren wieder erreicht wird. Läßt man grundsätzlich unterschiedliche Integrationszeiten zu, so kann die Steuereinrichtung z. B. mit Mitteln versehen sein, die bei Erreichen einer vorgegebenen Maximal- oder Minimalspannung an den Kondensatoren jeweils die Schaltvorrichtungen synchron umschalten. Die Zeiten $t_+$, $t'_+$, $t_-$, $t'_-$, $t''_+$ und $t''_-$ können dann voneinander verschieden, aber in jedem Integrationszyklus z. B. gleich sein. Falls die Abschnitte des Verfahrens in derselben Konstellation der Schaltpositionen beginnen, wird $t_+ = t'_+$ sein. Die geforderte Gleichheit der Summen der Beträge der jeweiligen Spannungsänderungen in einer Richtung ergibt sich dann automatisch aus der Gleichheit der Anzahlen von Lade und Entladevorgängen. Eine digitale Summierung der Integrationszeiten ist auch hierbei möglich, wenn die Steuereinrichtung getaktet ist.

Eine digitale Auswertung der Messung kann z. B. mit den in den Figuren 1 und 2 auf der rechten Seite im Schema dargestellten Schaltungsanordnungen vorgenommen werden. In diesem Beispiel erfolgen die Integrationszyklen jeweils zwischen einer Spannung $U_L$ und einer Spannung $U_H$. Die Steuereinrichtung 4 ist über zwei Differenzverstärker 10, 11 an den Ausgang des ersten Differenzverstärkers 3 angeschlossen. Einer der Eingänge dieser Differenzverstärker liegt jeweils auf dem Potential einer dieser Spannungen $U_L$, $U_H$. Es sind Zähler 12, 13, ein Dividierer 14 und ein Taktgeber 9 (Trigger) vorhanden. Diese Zähler 12, 13 werden von der Steuereinrichtung 4 ein- und ausgeschaltet und zählen die von dem Taktgeber gegebenen Zeiteinheiten. Der Zähler 12 kann zwischen Addition und Subtraktion umgeschaltet werden (Up/Down-Zähler), wofür die Steuerleitung 23 vorgesehen ist.

Die Messung gestaltet sich in der Weise, daß zunächst diese Zähler 12, 13 von der Steuereinrichtung 4 einen Rückstellbefehl über die entsprechende Steuerleitung 24 (RESET) auf einen Anfangswert ("NULL") erhalten. Die Messung der Kapazitäten beginnt, nachdem die Steuereinrichtung 4 die Schaltvorrichtungen 5, 6, 7 so geschaltet hat, daß die Kondensatoren z. B. auf die Spannung $U_L$ aufgeladen sind. Es werden dann die Schaltvorrichtungen für den ersten Integrationszyklus geschaltet. In dem Beispiel der Figur 1 wird z. B. der erste Schalter 5 in die Schaltposition $P_1$, der zweite Schalter 6 in die Schaltposition $P_1$ und der dritte Schalter 7 in die Schaltposition $P_2$ gebracht. Über die Steuerleitungen 22, 25 (ENABLE) werden gleichzeitig die Zähler 12, 13 gestartet. Solange die Spannung $U_H$ an den Kondensatoren noch nicht erreicht ist, addieren die Zähler die von dem Taktgeber gegebenen Zeitintervalle. Wenn die Spannung $U_H$ erreicht ist, schaltet die Steuereinrichtung die Schaltvorrichtungen um, so daß in diesem Beispiel die drei Schalter 5, 6, 7 in die jeweils andere Schaltposition umgeschaltet werden. Gleichzeitig wird über die Steuerleitung 23 (UP/DOWN) der erste Zähler 12 auf Subtraktion gestellt, so daß dieser Zähler jetzt die Zeitintervalle negativ zählt. Die Kondensatoren werden entladen, bis die Spannung $U_L$ erreicht wird. Dieser Integrationszyklus wird z. B. n-mal durchlaufen. Über die Steuerleitungen 21, 26 (ENABLE, LOAD) zwischen der Steuereinrichtung 4 und dem Dividierer 14 wird dann veranlaßt, die von den Zählern ermittelten Werte in den Dividierer 14 zu laden und die Division durchzuführen. Das Ergebnis dieser Division liefert sofort den Quotienten aus Summe und Differenz der Kapazitäten.

Die Anordnung nach Figur 2 umfaßt zwei weitere Zähler 15, 16, die dafür vorgesehen sind, festzustellen, ob die Summen aller Ladezeiten in den verschiedenen Abschnitten des Verfahrens gleich groß sind. Bei dieser Anordnung können alle Zähler 12, 13, 14, 15 zwischen Addition und Subtraktion umgeschaltet werden (Up/Down-Zähler), wofür die Steuerleitungen 23, 27, 29, 31 (UP/DOWN) vorgesehen sind. Die Steuerleitung 24 (RESET) übermittelt auch hier den Rückstellbefehl zum Ausgangszustand "NULL" an die Zähler, um eine neue Messung beginnen zu können. In dem ersten Abschnitt des Verfahrens, in dem z. B. in jedem Integrationszyklus der erste Schalter 5 und der dritte Schalter 7 jeweils synchron umgeschaltet werden, wird der dritte Zähler 15 über die entsprechende Steuerleitung 28 (ENABLE) auf Addition der von dem Taktgeber 9 gegebenen Zeitintervalle gestellt. In dem zweiten Abschnitt des Verfahrens werden jeweils der erste Schalter 5 und der zweite Schalter 6 synchron umgeschaltet. Damit die Summe aller Ladezeiten in diesem zweiten Abschnitt des Verfahrens, dessen Größen in den oben angegebenen Berechnungen jeweils mit einem Strich versehen sind, gleich der Summe der Ladezeiten in dem ersten Abschnitt des Verfahrens ist, wird nach dem Umschalten z. B. des dritten Zählers 15 über die Steuerleitung 29 (UP/DOWN) auf Subtraktion dieser Zählerwert bei jedem Zeitintervall vermindert, bis der Anfangswert ("NULL") wieder erreicht ist. Dann ist die Anzahl aller Ladezeiten in dem zweiten Abschnitt des Verfahrens gleich der Anzahl aller Ladezeiten in dem ersten Abschnitt des Verfahrens.

Mit dieser Art, das Verfahren auszuführen, kann z. B. der Quotient aus der Differenz und der Summe der zu messenden Kapazitäten nach der oben angegebenen Gleichung 2 bestimmt werden. Mit dem ersten Zähler 12 wird dann z. B. im Fall gleicher Beträge der Stromstärken der positiven Stromquelle +I und der negativen Stromquelle -I der Wert des Ausdruckes $\Sigma_g t_{-g} - \Sigma_i t'_{-i}$ bestimmt. Mit dem zweiten Zähler 13 wird der Wert des Ausdruckes $\Sigma_g t_{-g} + \Sigma_i t'_{-i} - 2 \Sigma_f t_{+f}$ bestimmt. Dazu werden zunächst alle Zähler über die Steuerleitung 24 (RESET) auf den Anfangswert ("NULL") zurückgestellt. Die Kondensatoren werden auf die Spannung $U_L$ aufgeladen. Die Messung beginnt mit allen drei Schaltern 5, 6, 7 in der Schaltposition $P_1$. Gleichzeitig wird der zweite Zähler 13 über die Steuerleitung 25 (ENABLE) gestartet und über die Steuerleitung 27 (UP/DOWN) auf Subtraktion gestellt. Der dritte Zähler 15 wird über die Steuerleitung 28 für Addition gestartet. Dann erfolgt der Ladevorgang, bis die Spannung auf den Kondensatoren von $U_L$ auf $U_H$ angestiegen ist. Dann werden von der Steuereinrichtung 4 der erste Schalter 5 und der dritte Schalter 7 in die andere Schaltposition $P_2$ umgeschaltet. Gleichzeitig wird über die Steuerleitung 22 (ENABLE) der erste Zähler 12 gestartet, über die Steuerleitung 27 (UP/DOWN) der zweite Zähler 13 auf Addition umgeschaltet und der dritte Zähler 15 gestoppt. Wenn sich bei dem nachfolgenden Entladevorgang die Spannung auf den Kondensatoren von $U_H$ zum Wert $U_L$ geändert hat, schaltet die Steuereinrichtung 4 erneut den ersten Schalter 5 und den dritten Schalter 7 in die erste Schaltposition $P_1$. Der erste Zähler 12 wird über die Steuerleitung 22 gestoppt, der zweite Zähler 13 wird über die Steuerleitung 27 (UP/DOWN) auf Subtraktion umgeschaltet, und der dritte Zähler 15 wird über die Steuerleitung 28 (ENABLE) für Addition gestartet. Dieser Integrationszyklus wird so oft wie vorgesehen wiederholt.

Dann beginnt der zweite Abschnitt des Verfahrens. Die Steuereinrichtung 4 stellt die Schalter 5, 6, 7 jeweils in die Schaltposition $P_1$, stoppt den ersten Zähler 12 über die Steuerleitung 22, startet den zweiten Zähler 13 über die Steuerleitung 25 und schaltet ihn über die Steuerleitung 27 auf Subtraktion und startet den dritten Zähler 15 über die Steuerleitung 28 und schaltet ihn gleichzeitig über die Steuerleitung 29 (UP/DOWN) auf Subtraktion. Ausgehend von der Spannung $U_L$ auf den Kondensatoren erfolgt der Ladevorgang, bis die Spannung $U_H$ erreicht ist. Dann schaltet die Steuereinrichtung 4 den ersten Schalter 5 und den zweiten Schalter 6 jeweils in die andere Schaltposition $P_2$. Gleichzeitig wird über die Steuerleitung 22 und die Steuerleitung 23 der erste Zähler 12 gestartet und auf Subtraktion gestellt, über die Steuerleitung 27 der zweite Zähler 13 auf Addition gestellt und über die Steuerleitung 28 der dritte Zähler 15 gestoppt. Wenn sich bei dem nachfolgenden Entladevorgang die Spannung auf den Kondensatoren von $U_H$ zum Wert $U_L$ geändert hat, schaltet die Steuereinrichtung 4 erneut den ersten Schalter 5 und den zweiten Schalter 6 in die erste Schaltposition $P_1$. Dieser Integrationszyklus wird im zweiten Abschnitt des Verfahrens so oft wiederholt, bis der dritte Zähler 15 den Anfangswert ("NULL") erreicht hat. Über die Steuerleitungen 21, 26 (ENABLE, LOAD) zwischen der Steuereinrichtung 4 und dem Dividierer 14 wird dann veranlaßt, die von dem ersten Zähler 12 und von dem zweiten Zähler 13 ermittelten Werte in den Dividierer 14 zu laden und die Division durchzuführen.

Falls die Beträge der Stromstärken der positiven und der negativen Stromquelle nicht gleich sind und deren Quotient ermittelt werden muß, kann der ansonsten überflüssige vierte Zähler 16 dazu verwendet werden, auch für einen dritten Abschnitt des Verfahrens die gleiche Summe der gesamten Ladezeiten sicherzustellen. Zu diesem Zweck wird der vierte Zähler 16 zusammen mit dem dritten Zähler 15 für Addition gestartet. Dafür ist die Steuerleitung 30 (ENABLE) vorgesehen. In dem zweiten Abschnitt des Verfahrens, in dem der dritte Zähler 15 subtrahiert, bleibt der vierte Zähler 16 abgeschaltet. In einem dritten Abschnitt des Verfahrens wird dann über die betreffende Steuerleitung 31 (UP/DOWN) dieser Zähler 16 auf Subtraktion gestellt und dieser dritte Abschnitt des Verfahrens solange fortgesetzt, bis der vierte Zähler 16 den Anfangswert ("NULL") anzeigt. Bei einer Bezugsmessung mit $C = C_0$ befinden sich der zweite Schalter 6 und der dritte Schalter 7 beide in der Schaltposition $P_1$, während der erste Schalter 5 jeweils zwischen den Schaltpositionen umgeschaltet wird. Der erste Zähler 12 und der zweite Zähler 13 werden über die Steuerleitungen 22, 25 so gestartet und über die Steuerleitungen 23, 27 zwischen Addition und Subtraktion so umgeschaltet, daß z. B. der erste Zähler 12 den Wert $\Sigma_g t_{-g} - \Sigma_i t'_{-i}$ und der zweite Zähler 13 den Wert $\Sigma_g t_{-g} + \Sigma_i t'_{-i} - 2 \Sigma_k t''_{-k}$ ermittelt. Über die Steuerleitungen 21 und 26 kann von der Steuereinrichtung 4 dann wieder der Dividierer angewiesen werden, diese von dem ersten Zähler 12 und dem zweiten Zähler 13 ermittelten Werte zu dividieren. Der dritte Zähler 15 und der vierte Zähler 16 werden von der Steuereinrichtung so über die Steuerleitungen 28, 30 gestartet oder gestoppt und über die Steuerleitungen 29, 31 von Addition auf Subtraktion umgeschaltet, daß in einem Abschnitt des Verfahrens entweder nur bei den Ladevorgängen die betreffende Anzahl der Zeitintervalle von beiden Zählern addiert wird oder jeweils von einem Zähler von dem zuvor erhaltenen Wert bis auf den Anfangswert herab subtrahiert wird. Durch Verwendung eines dritten Zählers 15, der ein Signal an die Steuereinrichtung 4 abgibt, falls der Anfangswert wieder erreicht ist, kann also zusätzlich für zwei Abschnitte des Verfahrens $\Sigma_f t_{+f} = \Sigma_h t'_{+h}$ erreicht werden. Mit dem vierten Zähler 16 kann die Gleichheit der Summe der Zeitintervalle auch für einen dritten Abschnitt erreicht werden, also $\Sigma_f t_{+f} = \Sigma_j t''_{+j}$.

Eine zweckmäßige Durchführung dieses Verfahrens mit Bezugsmessungen unter Verwendung aller vier Zähler gestaltet sich im einzelnen wie folgt. Zunächst werden alle Kondensatoren 1, 2, 8 bei geeigneten Schaltpositionen der Schalter über die Stromquellen auf die Spannung $U_L$ geladen. Die Steuereinrichtung 4 schaltet dann den ersten Schalter 5, den zweiten Schalter 6 und den dritten Schalter 7 jeweils in die erste Schaltposition $P_1$. Gleichzeitig mit dem Beginn der Integration werden der dritte Zähler 15 über die Steuerleitung 28 und der vierte Zähler 16 über die Steuerleitung 30 für Addition gestartet. Wenn die Spannung $U_H$ auf den Kondensatoren erreicht ist, schaltet die Steuereinrichtung den ersten Schalter 5 und den dritten Schalter 7 in die andere Schaltposition $P_2$. Gleichzeitig werden der erste Zähler 12 über die Steuerleitung 22 und der zweite Zähler 13 über die Steuerleitung 25 für Addition gestartet und der dritte Zähler 15 und der vierte Zähler 16 gestoppt. Wenn bei dem Entladevorgang die Ausgangsspannung $U_L$ auf den Kondensatoren wieder erreicht ist, ist der erste Integrationszyklus beendet. Die Steuereinrichtung stoppt über die Steuerleitungen 22, 25 den ersten Zähler und den zweiten Zähler, schaltet den ersten Schalter 5 und den dritten Schalter 7 erneut in die Schaltposition $P_1$ und startet den dritten Zähler 15 und den vierten Zähler 16 über die Steuerleitungen 28, 30 erneut für Addition.

Nachdem die vorgesehene Anzahl von Integrationszyklen durchlaufen wurde, stoppt die Steuereinheit die Zähler, schaltet den ersten Schalter 5, den zweiten Schalter 6 und den dritten Schalter 7 jeweils in die Schaltposition $P_1$ und startet den dritten Zähler 15 über die Steuerleitung 28 und schaltet diesen Zähler über die Steuerleitung 29 auf Subtraktion. Der Ladevorgang erfolgt dann erneut, bis auf den Kondensatoren die Spannung $U_H$ erreicht ist. Der dritte Zähler 15 wird dann über die Steuerleitung 28 gestoppt. Bei diesem zweiten Abschnitt des Verfahrens werden vor dem Entladen der Kondensatoren der erste Schalter 5 und der zweite Schalter 6 in die jeweils andere Schaltposition $P_2$ umgeschaltet, der erste Zähler 12 über die Steuerleitungen 22 und 23 für Subtraktion gestartet und der zweite Zähler 13 über die Steuerleitung 25 für Addition gestartet. Wenn die Kondensatoren bei dem Entladevorgang den Wert $U_L$ der Spannung wieder erreicht haben, werden die Zähler gestoppt, und ein neuer Integrationszyklus kann beginnen. Dazu schaltet die Steuereinrichtung den ersten Schalter 5 und den zweiten Schalter 6 erneut in die Schaltposition $P_1$ und startet den dritten Zähler 15 über die Steuerleitung 28 erneut für Subtraktion. Die Integrationszyklen in diesem zweiten Abschnitt des Verfahrens werden so oft durchgeführt, bis der dritte Zähler 13 den Anfangswert ("NULL") wieder erreicht hat.

Dann beginnt der dritte Abschnitt des Verfahrens, in dem die Schalter zunächst alle in Schaltposition $P_1$ gestellt werden und über die Steuerleitungen 30 und 31 der vierte Zähler 16 für Subtraktion gestartet wird. Nachdem die Kondensatoren auf die Spannung $U_H$ geladen sind, schaltet die Steuereinrichtung den ersten Schalter 5 in die Schaltposition $P_2$, startet über die Steuerleitungen 25 und 27 den zweiten Zähler 13 für Subtraktion mit doppelter Schrittweite (d. h. es werden die Zeitintervalle doppelt gezählt) und stoppt über die Steuerleitung 30 den vierten Zähler 16. Wenn erneut die Spannung $U_L$ auf den Kondensatoren erreicht ist, ist dieser Integrationszyklus des dritten Abschnittes beendet. Alle Schalter werden wieder in die Schaltposition $P_1$ gebracht, der zweite Zähler 13 wird gestoppt und der vierte Zähler 16 wird über die Steuerleitung 30 erneut für Subtraktion gestartet. Diese Integrationszyklen werden so oft wiederholt, bis der vierte Zähler 16 seinen Anfangswert ("NULL") wieder erreicht hat. Die Werte, die dann in dem ersten Zähler 12 und in dem zweiten Zähler 13 gespeichert sind, können dann wieder für die Division in den Dividierer 14 geladen werden, was über die Steuerleitungen 21 und 26 veranlaßt wird. Die weitere Auswertung erfolgt wie zuvor beschrieben.

Ergänzend sei noch angeführt, daß unter einem synchronen Umschalten der Schaltvorrichtungen auch der Vorgang zu verstehen ist, bei dem zunächst die Stromquellen abgeschaltet werden, d. h. der erste Schalter 5 weder mit dem einen noch mit dem anderen Anschluß verbunden wird, dann die übrigen Schalter umgeschaltet werden und danach erst der Anschluß mit der Stromquelle hergestellt wird. Auf diese Weise sind auch solche Ausführungsformen des Verfahrens mit eingeschlossen, bei denen z. B. aufgrund einer gewissen Trägheit der Schaltvorrichtungen eine ausreichend zeitgleiche Umschaltung nicht erfolgen kann. Es wird dann zunächst die Stromquelle abgeschaltet, dann alle Schalter in die neue Konstellation der Schaltpositionen gebracht und dann erst die Stromquelle über den ersten Schalter 5 angeschlossen. Im Sinne des erfindungsgemä-ßen Verfahrens ist auch dieser Vorgang als eine synchrone Umschaltung aufzufassen.

Die vorliegende Erfindung ermöglicht es also, auf einfache Weise eine digitale Messung von Kapazitätsunterschieden vorzunehmen ohne störenden Einfluß von parasitären Kapazitäten, wobei für die Ausgestaltung der Schaltungsanordnung keine hochgenauen Elemente benötigt werden. Das erfindungsgemäße Verfahren zur Eliminierung parasitärer Kapazitäten unter Verwendung der angegebenen Schaltungsanordnung ermöglicht speziell die Anwendung der Erfindung zur Auswertung der Meßergebnisse von mikromechanischen Sensoren.

**Patentansprüche**

1. Schaltungsanordnung zum Ermitteln der Differenz zwischen der Kapazität eines ersten Kondensators (1) und der Kapazität eines zweiten Kondensators (2),

bei der ein Differenzverstärker (3) mit einem invertierenden und einem nicht-invertierenden Eingang und mit einem Ausgang, eine positive Stromquelle (+I), die einen Strom mit konstanter Stromstärke und einer ersten Flußrichtung liefert, eine negative Stromquelle (-I), die einen Strom mit konstanter Stromstärke und der entgegengesetzten Flußrichtung liefert, ein Masseanschluß, eine Steuereinrichtung (4), eine erste Schaltvorrichtung (5) und eine zweite Schaltvorrichtung (6, 7) vorhanden sind,

bei der diese erste Schaltvorrichtung (5) zwei Schaltpositionen ($P_1$, $P_2$) aufweist, in denen jeweils diese positive Stromquelle (+I) oder diese negative Stromquelle (-I) mit dem invertierenden Eingang dieses Differenzverstärkers (3) verbunden ist, und

bei der der nicht-invertierende Eingang dieses Differenzverstärkers (3) mit diesem Masseanschluß verbunden ist, **dadurch gekennzeichnet, daß** diese zweite Schaltvorrichtung (6, 7) so eingerichtet ist, daß damit zwei verschiedene Schaltpositionen, in denen jeweils ein Anschluß eines dieser Kondensatoren (1, 2) mit einem der Eingänge des Differenzverstärkers (3) und ein Anschluß des anderen dieser Kondensatoren (1, 2) mit dem jeweils anderen Eingang dieses Differenzverstärkers verbunden ist, eingestellt werden können,

die anderen Anschlüsse dieser Kondensatoren mit dem Ausgang dieses Differenzverstärkers und einem Eingang dieser Steuereinrichtung (4) verbunden sind und

für diese Steuereinrichtung Mittel vorgesehen sind, mit denen diese erste und diese zweite Schaltvorrichtung (5; 6, 7) synchron umgeschaltet werden können, mit denen die Zeit zwischen zwei solchen Umschaltvorgängen und die an den Kondensatoren anliegende Spannung gemessen werden können, mit denen Zeiten addiert werden können und mit denen die für die Bestimmung der Kapazitätsdifferenz erforderlichen Werte ermittelt werden können.

2. Schaltungsanordnung nach Anspruch 1,

bei der die erste Schaltvorrichtung (5) ein erster Schalter (5) ist und die zweite Schaltvorrichtung (6, 7) ein zweiter Schalter (6) und ein dritter Schalter (7) ist,

bei der diese Schalter (5, 6, 7) jeweils alternativ in eine erste Schaltposition ($P_1$) und in eine zweite Schaltposition ($P_2$) gebracht werden können, in denen ein fester Anschluß des betreffenden Schalters jeweils mit einem von zwei alternierenden Anschlüssen verbunden ist,

bei der der feste Anschluß des ersten Schalters (5) mit dem invertierenden Eingang des Differenzverstärkers (3) und einer der alternierenden Anschlüsse des ersten Schalters (5) mit der positiven Stromquelle (+I) und der andere der alternierenden Anschlüsse des ersten Schalters (5) mit der negativen Stromquelle (-I) verbunden ist,

bei der entweder

a) der feste Anschluß des zweiten Schalters (6) mit einem Anschluß eines der Kondensatoren (1, 2) und der feste Anschluß des dritten Schalters (7) mit einem Anschluß des anderen Kondensators verbunden ist und jeweils einer der alternierenden Anschlüsse des zweiten und des dritten Schalters (6, 7) mit dem einen Eingang des Differenzverstärkers und der jeweils andere der alternierenden Anschlüsse mit dem jeweils anderen Eingang des Differenzverstärkers verbunden ist oder

b) der feste Anschluß des zweiten Schalters (6) mit einem Eingang des Differenzverstärkers und der feste Anschluß des dritten Schalters (7) mit dem anderen Eingang des Differenzverstärkers verbunden ist und jeweils einer der alternierenden Anschlüsse des zweiten und des dritten Schalters mit einem Anschluß eines der Kondensatoren (1, 2) und der jeweils andere der alternierenden Anschlüsse mit einem Anschluß des anderen Kondensators verbunden ist und

bei der für die Steuereinrichtung (4) Mittel vorgesehen sind, mit denen diese Schalter (5, 6, 7) wie für diese zweite Schaltvorrichtung vorgesehen synchron umgeschaltet werden können.

3. Schaltungsanordnung nach Anspruch 2,
bei der die Schalter (5, 6, 7) einzeln umgeschaltet werden können.

4. Schaltungsanordnung nach einem der Ansprüche 1 bis. 3,
bei der die positive und die negative Stromquelle (+I, -I) Ströme mit einer dem Betrag nach gleichen Stromstärke liefern.

5. Schaltungsanordnung nach einem der Ansprüche 1 bis 4,
bei der die erste Schaltvorrichtung (5) unabhängig von der zweiten Schaltvorrichtung (6, 7) umgeschaltet werden kann.

**6.** Schaltungsanordnung nach einem der Ansprüche 1 bis 5,
bei der die zweite Schaltvorrichtung (6, 7) eine Schaltposition ermöglicht, in der die mit einem Eingang des Differenzverstärkers verbundenen Anschlüsse der Kondensatoren beide mit dem Masseanschluß verbunden sind,
bei der die zweite Schaltvorrichtung zwischen dieser Schaltposition und jeder der beiden Schaltpositionen, in denen die mit einem Eingang des Differenzverstärkers verbundenen Anschlüsse der Kondensatoren mit verschiedenen Eingängen des Differenzverstärkers verbunden sind, synchron mit der ersten Schaltvorrichtung (5) umgeschaltet werden kann und
bei der die Steuereinrichtung (4) Mittel aufweist, mit denen zumindest für eine dieser Schaltpositionen jeweils erfolgende Änderungen der an den Kondensatoren anliegenden Spannung addiert werden können und diese Summe gespeichert werden kann.

**7.** Schaltungsanordnung nach Anspruch 6, bei der
die Steuereinrichtung (4) Mittel aufweist, mit denen zwischen Schaltpositionen umgeschaltet werden kann, sobald der Betrag der Summe der jeweils in einer bestimmten Konstellation der Schaltpositionen der Schaltvorrichtungen (5; 6, 7) erfolgenden Änderungen der an den Kondensatoren anliegenden Spannung den Betrag eines von der Steuereinrichtung gespeicherten Wertes erreicht.

**8.** Verfahren zum Ermitteln des Quotienten aus den Kapazitäten zweier Kondensatoren (1, 2) oder des Quotienten aus der Differenz und der Summe der Kapazitäten zweier Kondensatoren (1, 2) unter Verwendung einer Schaltungsanordnung nach einem der Ansprüche 1 bis 7, bei dem

a) der Quotient aus den Stromstärken des von der positiven Stromquelle (+I) gelieferten Stromes und des von der negativen Stromquelle (-I) gelieferten Stromes fest eingestellt wird, die erste Schaltvorrichtung (5) in eine erste Schaltposition ($P_1$) gebracht wird und die zweite Schaltvorrichtung (6, 7) so eingestellt wird, daß der eine Kondensator mit dem einen Eingang des Differenzverstärkers und der andere Kondensator mit dem anderen Eingang des Differenzverstärkers verbunden ist,
b) der mit der ersten Schaltvorrichtung verbundene Kondensator während einer vorgegebenen oder von der Steuereinrichtung (4) aus bisherigen Verfahrensschritten ermittelten Zeit geladen oder entladen wird, während der Differenzverstärker den anderen Kondensator auf dieselbe Spannung lädt,
c) die erste und die zweite Schaltvorrichtung synchron umgeschaltet werden, so daß die mit einem Eingang des Differenzverstärkers verbundenen Anschlüsse der Kondensatoren mit dem jeweils anderen Eingang des Differenzverstärkers verbunden werden,
d) der Schritt b) ausgeführt wird,
e) die Schritte c) und d) mehrmals hintereinander ausgeführt werden, wobei für jede der beiden Schaltpositionen, zwischen denen in Schritt c) umgeschaltet wird, gesondert die Zeiten, während derer Schritt b) oder d) ausgeführt worden ist, addiert werden und der Schritt d) so oft und jeweils so lange ausgeführt wird, daß die an den Kondensatoren anliegende Spannung anschließend mit der zu Anfang an den Kondensatoren anliegenden Spannung zumindest soweit übereinstimmt, wie für die vorgegebene Meßgenauigkeit erforderlich ist, und
f) der Quotient der Kapazitäten oder der Quotient aus der Differenz und der Summe der Kapazitäten der Kondensatoren aus dem bekannten oder separat ermittelten Quotienten der Stromstärken und den Summen der für die Schaltpositionen gesondert addierten Zeiten ermittelt wird.

**9.** Verfahren zum Ermitteln der Differenz der Kapazitäten zweier Kondensatoren (1, 2) oder des Quotienten aus der Differenz und der Summe der Kapazitäten zweier Kondensatoren (1, 2) unter Verwendung einer Schaltungsanordnung nach Anspruch 6 oder 7, bei dem

a) der Quotient aus den Stromstärken des von der positiven Stromquelle (+I) gelieferten Stromes und des von der negativen Stromquelle (-I) gelieferten Stromes fest eingestellt wird, die erste Schaltvorrichtung (5) in eine erste Schaltposition ($P_1$) gebracht wird und die zweite Schaltvorrichtung (6, 7) in eine von zwei speziellen Schaltpositionen A oder B eingestellt wird, in denen entweder

A) der eine Kondensator mit dem einen Eingang des Differenzverstärkers und der andere Kondensator mit dem anderen Eingang des Differenzverstärkers verbunden ist oder
B) die mit einem Eingang des Differenzverstärkers verbundenen Anschlüsse der Kondensatoren beide mit dem Masseanschluß verbunden sind,

b) ein zwischen dem invertierenden Eingang des Differenzverstärkers und dem Ausgang des Differenzverstärkers parallel zu dem Differenzverstärker vorhandener weiterer Kondensator (8) (Schaltungskomponente bestimmter Kapazität oder unbekannte parasitäre Kapazität) während einer vorgegebenen oder von der Steuereinrichtung aus bisherigen Verfahrensschritten ermittelten Zeit geladen oder entladen wird, während der Differenzverstärker den oder die anderen Kondensator(en) auf dieselbe Spannung lädt,

c) die erste und die zweite Schaltvorrichtung synchron umgeschaltet werden, so daß die Kondensatoren aus der eingestellten speziellen Schaltposition in die andere spezielle Schaltposition gelangen,

d) der Schritt b) ausgeführt wird,

e) die Schritte c) und d) mehrmals hintereinander ausgeführt werden, wobei für jede der beiden speziellen Schaltpositionen gesondert die Zeiten, während derer Schritt b) oder d) ausgeführt worden ist, addiert werden und zumindest für eine dieser speziellen Schaltpositionen gesondert die während dieser Zeiten jeweils erfolgenden Änderungen der an den Kondensatoren anliegenden Spannung addiert werden und der Schritt d) so oft und jeweils so lange ausgeführt wird, daß die an den Kondensatoren anliegende Spannung anschließend mit der zu Anfang an den Kondensatoren anliegenden Spannung zumindest soweit übereinstimmt, wie für die vorgegebene Meßgenauigkeit erforderlich ist, und die Summe der in dieser speziellen Schaltposition erfolgten Änderungen der an den Kondensatoren anliegenden Spannung von der Steuereinrichtung gespeichert wird,

f) die zweite Schaltvorrichtung (6, 7) in eine der zwei speziellen Schaltpositionen B oder C eingestellt wird, wobei in Schaltposition C der eine Kondensator mit dem einen Eingang des Differenzverstärkers und der andere Kondensator mit dem anderen Eingang des Differenzverstärkers verbunden ist und dabei die Anschlüsse gegenüber der speziellen Schaltposition A vertauscht sind,

g) der Schritt b) ausgeführt wird,

h) der Schritt c) ausgeführt wird, wobei zwischen den speziellen Schaltpositionen B und C umgeschaltet wird,

i) der Schritt b) ausgeführt wird,

j) die Schritte h) und i) mehrmals hintereinander ausgeführt werden und für diese beiden speziellen Schaltpositionen gesondert die Zeiten, während derer Schritt g) oder i) ausgeführt worden ist, addiert werden und zumindest für eine dieser speziellen Schaltpositionen gesondert die während dieser Zeiten jeweils erfolgenden Änderungen der an den Kondensatoren anliegenden Spannung addiert werden und entweder die Summe der in dieser speziellen Schaltposition erfolgten Änderungen der an den Kondensatoren anliegenden Spannung ebenfalls von der Steuereinrichtung gespeichert wird oder der Schritt i) in dieser speziellen Schaltposition so oft und jeweils so lange ausgeführt wird, daß der Betrag dieser Summe den Betrag des von der Steuereinrichtung in Schritt e) gespeicherten Wertes erreicht, und der Schritt i) insgesamt so oft und jeweils so lange ausgeführt wird, daß die an den Kondensatoren anliegende Spannung anschließend mit der zu Anfang an den Kondensatoren anliegenden Spannung zumindest soweit übereinstimmt, wie für die vorgegebene Meßgenauigkeit erforderlich ist, und

k) aus dem bekannten oder separat ermittelten Quotienten der Stromstärken, den Summen der für die Schaltpositionen gesondert addierten Zeiten und dem Quotienten der in den Schritten e) und j) jeweils erfaßten Summen der Änderungen der Spannung der Quotient aus der Differenz und der Summe der Kapazitäten der Kondensatoren ermittelt wird oder aus diesen Werten und dem bekannten oder separat bestimmten Wert der Kapazität des weiteren Kondensators (8) die Differenz der Kapazitäten der Kondensatoren ermittelt wird.

10. Verfahren nach Anspruch 8 oder 9, unter Verwendung einer Schaltungsanordnung nach Anspruch 5 oder nach einem der Ansprüche 6 oder 7, rückbezogen auf Anspruch 5, bei dem der Quotient aus den Stromstärken des von der positiven Stromquelle gelieferten Stromes und des von der negativen Stromquelle gelieferten Stromes ermittelt wird, indem

a) die erste Schaltvorrichtung in eine erste Schaltposition gebracht wird und die zweite Schaltvorrichtung so eingestellt wird, daß mindestens ein Kondensator mit der ersten Schaltvorrichtung verbunden ist,

b) dieser Kondensator während einer vorgegebenen oder von der Steuereinrichtung aus bisherigen Verfahrensschritten ermittelten Zeit geladen oder entladen wird,

c) nur die erste Schaltvorrichtung umgeschaltet wird,

d) der Schritt b) ausgeführt wird,

e) die Schritte c) und d) mehrmals hintereinander ausgeführt werden, wobei für jede der beiden Schaltpositionen der ersten Schaltvorrichtung gesondert die Zeiten, während derer Schritt b) oder d) ausgeführt worden ist, addiert werden und der Schritt d) so oft und jeweils so lange ausgeführt wird, daß die an dem Kondensator anliegende Spannung anschließend mit der zu Anfang an dem Kondensator anliegenden Spannung zumindest soweit übereinstimmt, wie für die vorgegebene Meßgenauigkeit erforderlich ist, und

f) der Quotient aus den Stromstärken des von der positiven Stromquelle gelieferten Stromes und des von der negativen Stromquelle gelieferten Stromes als Quotient aus der Summe der für die Schaltposition, in der der Kondensator mit der negativen Stromquelle verbunden ist, gesondert addierten Zeiten und der Summe der für die Schaltposition, in der der Kondensator mit der positiven Stromquelle verbunden ist, gesondert addierten Zeiten ermittelt wird.

**Claims**

1. Circuit arrangement for determining the difference between the capacitance of a first capacitor (1) and the capacitance of a second capacitor (2),
in which are present a differential amplifier (3) having an inverting input, a non-inverting input and an output, a positive current source (+I), which supplies a constant current flowing in a first direction, a negative current source (-I), which supplies a constant current flowing in the opposite direction, a ground terminal, a control device (4), a first switching device (5) and a second switching device (6, 7),
in which said first switching device (5) has two switching positions ($P_1$, $P_2$), in which positions said positive current source (+I) or said negative current source (-I) is connected respectively to the inverting input of said differential amplifier (3), and
in which the non-inverting input of said differential amplifier (3) is connected to said ground terminal,
**characterized in that**
said second switching device (6, 7) is configured so that it can be used to set two different switching positions, in which positions respectively a terminal of one of said capacitors (1, 2) is connected to one of the inputs of the differential amplifier (3), and a terminal of the other of said capacitors (1, 2) is connected to the other respective input of said differential amplifier,
the other terminals of said capacitors are connected to the output of said differential amplifier and to an input of said control device (4), and
means are provided for said control device, by which means said first and said second switching device (5; 6, 7) can be switched over synchronously, by which means the time between two such switchover operations and the voltage across the capacitors can be measured, by which means times can be summed, and by which means the values required to find the capacitance difference can be determined.

2. Circuit arrangement according to Claim 1,
in which the first switching device (5) is a first switch (5), and the second switching device (6, 7) is a second switch (6) and a third switch (7),
in which said switches (5, 6, 7) can each be brought alternatively into a first switching position ($P_1$) and into a second switching position ($P_2$), in which positions a fixed terminal of the switch concerned is connected to one of two alternate terminals respectively,
in which the fixed terminal of the first switch (5) is connected to the inverting input of the differential amplifier (3), and one of the alternate terminals of the first switch (5) is connected to the positive current source (+I), and the other terminal of the alternate terminals of the first switch (5) is connected to the negative current source (-I),
in which either

a) the fixed terminal of the second switch (6) is connected to a terminal of one of the capacitors (1, 2), and the fixed terminal of the third switch (7) is connected to a terminal of the other capacitor, and one of the alternate terminals of the second and third switch (6, 7) in each case is connected to the one input of the differential amplifier, and the other respective terminal of the alternate terminals is connected to the other respective input of the differential amplifier, or
b) the fixed terminal of the second switch (6) is connected to one input of the differential amplifier, and the fixed terminal of the third switch (7) is connected to the other input of the differential amplifier, and one of the alternate terminals of the second and the third switch in each case is connected to one terminal of one of the capacitors (1, 2), and the other respective terminal of the alternate terminals is connected to a terminal of the other capacitor, and

in which means are provided for the control device (4), by which means said switches (5, 6, 7) can be switched over synchronously as intended for said second switching device.

3. Switching arrangement according to Claim 2,
in which the switches (5, 6, 7) can be switched over individually.

4. Switching arrangement according to any of Claims 1 to 3,

in which the positive current source and negative current source (+I, -I) supply currents of equal magnitude.

5. Switching arrangement according to any of Claims 1 to 4,
in which the first switching device (5) can be switched over independently of the second switching device (6, 7).

6. Switching arrangement according to any of Claims 1 to 5,
in which the second switching device (6, 7) affords a switching position in which the terminals of the capacitors connected to one input of the differential amplifier are both connected to the ground terminal,
in which the second switching device can be switched over synchronously with the first switching device (5) between this switching position and each of the two switching positions in which the terminals of the capacitors connected to one input of the differential amplifier are connected to different inputs of the differential amplifier,
and in which the control device (4) has means by which respective resultant changes in the voltage across the capacitors can be summed at least for one of these switching positions and this sum can be saved.

7. Switching arrangement according to Claim 6, in which
the control device (4) has means by which it is possible to switch between switching positions as soon as the magnitude of the sum of the respective changes in the voltage across the capacitors resulting for a specific configuration of the switching positions of the switching devices (5; 6, 7) reaches the magnitude of a value saved by the control device.

8. Method to determine the quotient of the capacitances of two capacitors (1, 2) or the quotient of the difference and the sum of the capacitances of two capacitors (1, 2) using a switching arrangement according to any of Claims 1 to 7, in which

a) the quotient of the current supplied by the positive current source (+I) and the current supplied by the negative current source (-I) is fixed, the first switching device (5) is brought into a first switching position ($P_1$), and the second switching device (6, 7) is set so that the one capacitor is connected to the one input of the differential amplifier and the other capacitor is connected to the other input of the differential amplifier,
b) the capacitor connected to the first switching device is charged or discharged during a preset time or a time determined by the control device (4) from previous method steps, while the differential amplifier charges the other capacitor to the same voltage,
c) the first and the second switching devices are switched over synchronously so that the terminals of the capacitors connected to one input of the differential amplifier are connected to the other respective input of the differential amplifier,
d) step b) is performed,
e) steps c) and d) are successively performed a plurality of times, where the times during which step b) or d) has been performed are summed separately for each of the two switching positions switched between in step c), and step d) is performed so often and for so long in each case that the voltage across the capacitors then corresponds to the voltage across the capacitors at the beginning, at least as far as is necessary for the given measurement accuracy, and
f) the quotient of the capacitances or the quotient of the difference and the sum of the capacitances of the capacitors is determined from the known or separately determined quotient of the currents and the sums of the times summed separately for the switching positions.

9. Method to determine the difference of the capacitances of two capacitors (1, 2) or the quotient of the difference and the sum of the capacitances of two capacitors (1, 2) using a switching arrangement according to Claim 6 or 7, in which

a) the quotient of the current supplied by the positive current source (+I) and the current supplied by the negative current source (-I) is fixed, the first switching device (5) is brought into a first switching position ($P_1$), and the second switching device (6, 7) is set in one of two specific switching positions A or B, in which either

A) the one capacitor is connected to the one input of the differential amplifier and the other capacitor is connected to the other input of the differential amplifier, or
B) the terminals of the capacitors connected to one input of the differential amplifier are both connected to the ground terminal,

b) an additional capacitor (8) (circuit component of a given capacitance or unknown parasitic capacitance) present between the inverting input of the differential amplifier and the output of the differential amplifier, in parallel with the differential amplifier, is charged or discharged during a preset time or a time determined by the control device from previous method steps, while the differential amplifier charges the other capacitor(s) to the same voltage,

c) the first and the second switching devices are switched over synchronously, so that the capacitors attain the other specific switching position from the set specific switching position,

d) step b) is performed,

e) steps c) and d) are successively performed a plurality of times, where the times during which step b) or d) has been performed are summed separately for each of the two specific switching positions, and the respective changes in the voltage across the capacitors resulting during these times are summed separately at least for one of these specific switching positions and step d) is performed so often and for so long in each case that the voltage across the capacitors then corresponds to the voltage across the capacitors at the beginning, at least as far as is necessary for the given measurement accuracy, and the sum of the changes in the voltage across the capacitors resultant in this specific switching position is saved by the control device,

f) the second switching device (6, 7) is set into one of the two specific switching positions B or C, where in switching position C the one capacitor is connected to the one input of the differential amplifier and the other capacitor is connected to the other input of the differential amplifier, the terminals being swapped over with respect to the specific switching position A,

g) step b) is performed,

h) step c) is performed, where switching is between the specific switching positions B and C,

i) step b) is performed,

j) steps h) and i) are successively performed a plurality of times, and the times during which step g) or i) has been performed are summed separately for these two specific switching positions, and the respective changes in the voltage across the capacitors resulting during these times are summed at least for one of these specific switching positions, and either the sum of the changes in the voltage across the capacitors resultant in this specific switching position is also saved by the control device, or step i) is performed in this specific switching position so often and for so long in each case that the magnitude of this sum reaches the magnitude of the value saved by the control device in step e), and step i) is performed in total so often and for so long in each case that the voltage across the capacitors then corresponds to the voltage across the capacitors at the beginning, at least as far as is necessary for the given measurement accuracy, and

k) from the known or separately determined quotient of the currents, from the sums of the times separately summed for the switching positions and from the quotient of the sums of the changes in the voltage found in steps e) and j) respectively, the quotient of the difference and the sum of the capacitances of the capacitors is determined, or from these values and the known or separately determined value of the capacitance of the additional capacitor (8), the difference in the capacitances of the capacitors is determined.

10. Method according to Claim 8 or 8, using a switching arrangement according to Claim 5 or one of Claims 6 or 7, referred to Claim 5, in which the quotient of the current supplied by the positive current source and the current supplied by the negative current source is determined, by

a) the first switching device being brought into a first switching position and the second switching device being set so that at least one capacitor is connected to the first switching device,

b) this capacitor being charged or discharged during a preset time or a time determined by the control device from previous method steps,

c) only the first switching device being switched over,

d) step b) being performed,

e) steps c) and d) being successively performed a plurality times, where the times during which step b) or d) has been performed are summed separately for each of the two switching positions of the first switching device, and step d) is performed so often and for so long in each case that the voltage across the capacitor then corresponds to the voltage across the capacitor at the beginning, at least as far as is necessary for the given measurement accuracy, and

f) the quotient of the current supplied by the positive current source and the current supplied by the negative current source is determined as the quotient of the sum of the times summed separately for the switching position in which the capacitor is connected to the negative current source, and the sum of the times summed separately for the switching position in which the capacitor is connected to the positive current source.

**Revendications**

1. Circuit de détermination de la différence entre la capacité d'un premier condensateur (1) et la capacité d'un deuxième condensateur (2),

   dans lequel il y a un amplificateur (3) différentiel ayant une entrée inverseuse et une entrée non inverseuse et une sortie, une source (+I) positive de courant, qui fournit un courant d'une intensité constante et d'un premier sens, une source (-I) négative de courant, qui fournit un courant d'une intensité constante et d'un sens opposé, une borne de masse, un dispositif (4) de commande, un premier dispositif (5) de commutation et un deuxième dispositif (6, 7) de commutation,

   dans lequel le premier dispositif (5) de commutation a deux positions ($P_1$, $P_2$) de commutation, dans lesquelles, respectivement, cette source (+I) positive de courant ou cette source (-I) négative de courant est reliée à l'entrée inverseuse de cet amplificateur (3) différentiel et

   dans lequel l'entrée non inverseuse de cet amplificateur (3) différentiel est reliée à cette borne de masse, **caractérisé en ce que** ce deuxième dispositif (6, 7) de commutation est tel qu'il peut ainsi s'établir deux positions de commutation différentes dans lesquelles, respectivement, une borne de l'un de ces condensateurs (1, 2) est reliée à l'une des entrées de l'amplificateur (3) différentiel et une borne de l'autre de ces condensateurs (1, 2) est reliée à respectivement l'autre entrée de cet amplificateur différentiel,

   les autres bornes de ces condensateurs sont reliées à la sortie de cet amplificateur différentiel et à une entrée de ce dispositif (4) de commande et

   il est prévu pour ce dispositif de commande des moyens par lesquels ce premier et ce deuxième dispositifs (5, 6, 7) de commutation peuvent être commutés en synchronisme, par lesquels la durée entre deux opérations de commutation de ce genre et la tension appliquée au condensateur peuvent être mesurées, par lesquels des temps peuvent être additionnés et par lesquels des valeurs nécessaires à la détermination de la différence de capacité peuvent être déterminées.

2. Circuit suivant la revendication 1,

   dans lequel le premier dispositif (5) de commutation est un premier commutateur (5) et le deuxième dispositif (6, 7) de commutation est un deuxième commutateur (6) et un troisième commutateur (7),

   dans lequel ces commutateurs (5, 6, 7) sont mis respectivement en alternance dans une première position ($P_1$) de commutation et dans une deuxième position ($P_2$) de commutation, dans lesquelles une borne fixe du commutateur concerné est reliée respectivement à l'une de deux bornes en alternance,

   dans lequel la borne fixe du premier commutateur (5) est reliée à l'entrée inverseuse de l'amplificateur (3) différentiel et l'une des bornes en alternance du premier commutateur (5) est reliée à la source (+I) positive de courant et l'autre des bornes en alternance du premier commutateur (5) à la source (-I) négative de courant,

   dans lequel soit

   a) la borne fixe du deuxième commutateur (6) est reliée à une borne de l'un des condensateurs (1, 2) et la borne fixe du troisième commutateur (7) à une borne de l'autre condensateur et, respectivement, l'une des bornes en alternance du deuxième et du troisième commutateur (6, 7) est reliée à l'une des entrées de l'amplificateur différentiel et l'autre des bornes en alternance à respectivement l'autre entrée de l'amplificateur différentiel, soit

   b) la borne fixe du deuxième commutateur (6) est reliée à une entrée de l'amplificateur différentiel et la borne fixe du troisième commutateur (7) est reliée à l'autre entrée de l'amplificateur différentiel et respectivement l'une des bornes en alternance du deuxième et du troisième commutateur est reliée à une borne de l'un des condensateurs (1, 2) et l'autre des bornes en alternance à une borne de l'autre condensateur et

   dans lequel il est prévu pour le dispositif (4) de commande des moyens par lesquels ces commutateurs (5, 6, 7), comme cela est prévu pour ce deuxième dispositif de commutation, peuvent être commutés en synchronisme.

3. Circuit suivant la revendication 2,

   dans lequel les commutateurs (5, 6, 7) peuvent être commutés individuellement.

4. Circuit suivant l'une des revendications 1 à 3,

   dans lequel les sources (+I, -I) positive et négative de courant fournissent des courants ayant en valeur absolue la même intensité.

5. Circuit suivant l'une des revendications 1 à 4,

   dans lequel le premier dispositif (5) de commutation peut être commuté indépendamment du deuxième dispositif (6, 7) de commutation.

6. Circuit suivant l'une des revendications 1 à 5,
dans lequel le deuxième dispositif (6, 7) de commutation autorise une position de commutation, dans laquelle les bornes des condensateurs reliées à une entrée de l'amplificateur différentiel sont reliées toutes les deux à la borne de masse,
dans lequel le deuxième dispositif de commutation peut être commuté en synchronisme avec le premier dispositif (5) de commutation entre cette position de commutation et chacune des deux positions de commutation,
dans lesquelles les bornes des condensateurs reliées à une entrée d'amplificateur différentiel sont reliées à des entrées différentes de l'amplificateur différentiel et
dans lequel le dispositif (4) de commande a des moyens par lesquels, au moins pour l'une de ces positions de commutation, des modifications qui ont lieu de la tension appliquée aux condensateurs peuvent être additionnées et cette somme peut être mémorisée.

7. Circuit suivant la revendication 6, dans lequel
le dispositif (4) de commande a des moyens par lesquels on peut commuter entre des positions de commutation dès que la valeur absolue de la somme des modifications, se produisant respectivement dans une certaine configuration des positions de commutation des dispositifs (5, 6, 7) de commutation, de la tension appliquée aux condensateurs atteint la valeur absolue d'une valeur mémorisée par le dispositif de commande.

8. Procédé de détermination du quotient des capacités de deux condensateurs (1 2) ou du quotient de la différence et de la somme des capacités de deux condensateurs (1, 2) en utilisant un circuit suivant l'une des revendications 1 à 7, dans lequel

   a) on fixe le quotient des intensités du courant fourni par la source (+I) positive de courant et du courant fourni par la source (-I) négative de courant, on met le premier dispositif (5) de commutation dans une première position ($P_1$) de commutation et on règle le deuxième dispositif (6, 7) de commutation de façon à ce que l'un des condensateurs soit relié à une entrée de l'amplificateur différentiel et l'autre condensateur à l'autre entrée de l'amplificateur différentiel,
   b) on charge ou on décharge le condensateur relié au premier dispositif de commutation pendant une durée prescrite ou déterminée par le dispositif (4) de commande à partir des stades de procédé antérieurs, tandis que l'amplificateur différentiel charge l'autre condensateur jusqu'à la même tension,
   c) on commute en synchronisme le premier et le deuxième dispositif de commutation, de sorte que les bornes des condensateurs reliées à une entrée d'amplificateur différentiel soient reliées à respectivement l'autre entrée de l'amplificateur différentiel,
   d) on effectue le stade b),
   e) on effectue le stade c) et d) plusieurs fois successivement en additionnant, pour chacune des deux positions de commutation entre lesquelles on commute au stade c), séparément les temps pendant lesquels leur stade b) ou d) a été effectué et on effectue le stade d) aussi souvent et respectivement aussi longtemps qu'il le faut pour que la tension appliquée aux condensateurs coïncide ensuite avec la tension appliquée au début aux condensateurs au moins dans la mesure nécessaire pour la précision prescrite de la mesure et
   f) on détermine le quotient des capacités ou le quotient de la différence et de la somme des capacités des condensateurs à partir des quotients connus ou déterminés séparément, des intensités de courant et des sommes des temps additionnées séparément pour les positions de commutation.

9. Procédé de détermination de la différence des capacités de deux condensateurs (1, 2) ou du quotient de la différence et de la somme des capacités de deux condensateurs (1, 2) en utilisant un circuit suivant la revendication 6 ou 7, dans lequel

   a) on fixe le quotient des intensités du courant fourni par la source (+I) positive de courant et du courant fourni par la source (-I) négative de courant, on met le premier dispositif (5) de commutation dans une première position ($P_1$) de commutation et on règle le deuxième dispositif (6, 7) de commutation dans l'une de deux positions A ou B spéciales de commutation, dans lesquelles ou bien

   A) l'un des condensateurs est relié à l'une des entrées de l'amplificateur différentiel et l'autre condensateur à l'autre entrée de l'amplificateur différentiel ou bien
   B) les bornes du condensateur reliées à l'une des entrées de l'amplificateur différentiel sont reliées toutes deux à la borne de masse,

b) on charge ou on décharge un autre condensateur (8) présent entre l'entrée inverseuse de l'amplificateur différentiel et la sortie de l'amplificateur différentiel en parallèle à l'amplificateur différentiel (composant de circuit d'une certaine capacité ou d'une capacité parasite inconnue) pendant une durée prescrite ou déterminée par le dispositif de commande à partir de stades antérieurs de procédé, tandis que l'amplificateur différentiel charge le ou les autres condensateurs jusqu'à la même tension,

c) on commute le premier et le deuxième dispositif de commutation en synchronisme, de sorte que les condensateurs arrivent à partir de la position de commutation spéciale établie à l'autre position de commutation spéciale,

d) on effectue le stade b)

e) on effectue les stades c) et d) plusieurs fois successivement en additionnant pour chacune des deux positions spéciales de commutation, séparément, les temps pendant lesquels leur stade b) ou d) a été effectué et on additionne, au moins pour l'une de ces positions spéciales de commutation, séparément, les variations se produisant respectivement pendant ces temps de la tension appliquée aux condensateurs et on effectue le stade d) aussi souvent, respectivement aussi longtemps, jusqu'à ce que la tension appliquée aux condensateurs coïncide ensuite avec la tension appliquée au début aux condensateurs, au moins dans la mesure où cela est nécessaire pour la précision prescrite de la mesure et on mémorise par le dispositif de commande la somme des modifications, se produisant dans cette position spéciale de commutation, de la tension appliquée aux condensateurs,

f) on met le deuxième dispositif (6, 7) de commutation dans l'une des deux positions B ou C spéciales de commutation, dans la position C de commutation un condensateur étant relié à l'une des entrées de l'amplificateur différentiel et l'autre condensateur à l'autre entrée de l'amplificateur différentiel et ainsi les bornes étant échangées par rapport à la position A spéciale de commutation,

g) on effectue le stade b),

h) on effectue le stade c) en commutant, entre les positions B et C spéciales de commutation,

i) on effectue le stade b),

j) on effectue plusieurs fois successivement les stades h) et i) et pour ces deux positions spéciales de commutation, on additionne séparément les temps pendant lesquels leur stade g) ou i) ont été effectués et on additionne, au moins pour l'une de ces positions spéciales de commutation, séparément les modifications, s'effectuant pendant ces temps, de la tension appliquée aux condensateurs et ou bien on mémorise également par le dispositif de commande la somme des modifications, se produisant dans cette position spéciale de commutation, de la tension appliquée aux condensateurs ou bien on effectue le stade i) dans cette position spéciale de commutation aussi souvent et respectivement aussi longtemps pour que la valeur absolue de cette somme atteigne la valeur absolue de la valeur mémorisée par le dispositif de commande au stade e) et on effectue le stade i) dans l'ensemble aussi souvent et respectivement aussi longtemps pour que la tension appliquée aux condensateurs coïncide ensuite avec la tension appliquée au début aux condensateurs, au moins dans la mesure où cela est nécessaire pour la précision de mesure qui est prescrite et

k) à partir du quotient connu ou déterminé séparément, les intensités de courant des sommes des temps additionnées séparément pour les positions de commutation et du quotient des sommes des modifications de la tension détectées, respectivement, aux stades e) et j), on détermine le quotient de la différence et de la somme des capacités des condensateurs ou, à partir de ces valeurs et de la valeur connue ou déterminée séparément de la capacité de l'autre condensateur (8), on détermine la différence de capacité des condensateurs.

**10.** Procédé suivant la revendication 8 ou 9, en utilisant un circuit suivant la revendication 5 ou suivant l'une des revendications 6 ou 7 se rapportant à la revendication 5, dans lequel on détermine le quotient des intensités du courant fourni par la source positive de courant et du courant fourni par la source négative de courant,

a) en mettant le premier dispositif de commutation dans une première position de commutation et en réglant le deuxième dispositif de commutation de façon à ce qu'au moins un condensateur soit relié au premier dispositif de commutation,

b) en chargeant ou en déchargeant ce condensateur pendant un temps prescrit ou déterminé par le dispositif de commande à partir des stades antérieurs du procédé et

c) en ne commutant que le premier dispositif de commutation,

d) en effectuant un stade b),

e) en effectuant plusieurs fois successivement les stades c) et d), en additionnant pour chacune des deux positions de commutation du premier dispositif de commutation, séparément, les temps pendant lesquels leur stade b) ou d) a été effectué et en effectuant le stade d) aussi souvent et respectivement aussi longtemps pour que la tension appliquée au condensateur coïncide ensuite avec la tension appliquée au début au condensateur au moins dans la mesure où cela est nécessaire pour la précision de mesure prescrite et

f) on détermine le quotient à partir des intensités du courant fourni par la source positive de courant et du courant fourni par la source négative de courant en tant que quotient de la somme des temps additionnés séparément pour la position de commutation dans laquelle le condensateur est relié à la source négative de courant et de la somme des temps additionnés séparément pour la position de commutation, dans laquelle le condensateur est relié à la source positive de courant.

FIG 1

EP 0 741 299 B1

FIG 2

EP 0 741 299 B1